Europäisches Patentamt

European Patent Office

Office européen des brevets

(19)

(11) **EP 0 597 535 B1**

(12) **FASCICULE DE BREVET EUROPEEN**

(45) Date de publication et mention
de la délivrance du brevet:
**12.08.1998   Bulletin 1998/33**

(51) Int Cl.6: **G11C 19/28**

(21) Numéro de dépôt: **93203104.0**

(22) Date de dépôt: **05.11.1993**

(54) **Registre à décalage numérique à fonctionnement accéléré et montage comprenant un tel registre**

Numerisches Schieberegister mit erhöhter Wirkung und Schaltkreis mit einem solchen Register

Numerical shift register with boosted functioning and a circuit comprising such a register

(84) Etats contractants désignés:
**DE FR GB IT**

(30) Priorité: **12.11.1992   FR 9213613**

(43) Date de publication de la demande:
**18.05.1994   Bulletin 1994/20**

(73) Titulaires:
• **PHILIPS COMPOSANTS ET SEMICONDUCTEURS**
  **92150 Suresnes (FR)**
  Etats contractants désignés:
  **FR**
• **Philips Electronics N.V.**
  **5621 BA Eindhoven (NL)**
  Etats contractants désignés:
  **DE GB IT**

(72) Inventeur: **Lepailleur, Laurent**
**F-75008 Paris (FR)**

(74) Mandataire: **Charpail, François et al**
**Société Civile S.P.I.D.**
**156, Boulevard Haussmann**
**75008 Paris (FR)**

(56) Documents cités:
• ELECTRONICS LETTERS vol. 26, no. 8 , 14 Avril 1990 , ENAGE GB pages 553 - 555 WUPPERMANN '3-4 GHZ BIPOLAR VERSATILE SHIFT REGISTER AND 6-8 GBITS WORD GENERATOR'
• PROCEEDINGS OF THE 1987 BIPOLAR CIRCUITS AND TECHNOLOGY MEETING Septembre 1987 , MINNEAPOLIS USA pages 109 - 112 LANGMANN ET AL. 'A 2.25 GHZ SILICON BIPOLAR SHIFT REGISTER'

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

## Description

La présente invention a pour objet un registre à décalage numérique comportant une succession de plusieurs bascules maître-esclaves commandées par un signal d'horloge afin de charger en série des données présentes à l'entrée du registre à décalage, certaines de ces bascules étant séparées par un dispositif de commutation qui comporte :

-   un étage différentiel de transistors, dit étage série,
-   un étage différentiel de transistors, dit étage parallèle,
-   et un circuit commutateur qui permet de fournir un courant, dit courant de valeur nominale, soit à l'étage série soit à l'étage parallèle en fonction d'un signal de sélection, pour charger la bascule qui suit ce dispositif de commutation soit en mode série, soit en mode parallèle, à partir de données présentes soit sur une entrée de l'étage série, soit sur une entrée de l'étage parallèle.

Un tel registre à décalage a d'importantes applications, en particulier pour le traitement numérique d'un signal vidéo en aval de convertisseurs analogique-numérique. En effet, pour certaines applications, par exemple lorsque les données à enregistrer dans le registre sont toutes disponibles au même instant, le chargement en série constitue une perte de temps.

Un registre à décalage pouvant être chargé soit en mode série soit en mode parallèle est décrit dans l'article "A 2.25-GHz silicon bipolar shift register" de U. Langmann, extrait des "Proceedings of the 1987 bipolar circuits and technology meeting", pages 109 à 112, édité par J.Jopke et publié par l'IEEE. Ce registre à décalage est réalisé en logique CML (de l'anglais Current Mode Logic).

Le but de la présente invention est de proposer un registre à décalage pouvant être chargé soit en série soit en parallèle et réalisé en logique CRL (de l'anglais Current Routing Logic). Le principe et les nombreux avantages de cette logique sont exposés dans l'article "Analysis and improvement of a static shift register" de D. Kasperkovitz, publié dans la revue "Microelectronics & Reliability, p501-515, Pergamon Press 1974".

Pour cela, un registre à décalage numérique selon l'invention et tel que défini dans le paragraphe introductif est caractérisé en ce que :

-   ■ les bascules maîtres-esclaves étant réalisées à partir de cellules en logique CRL, le dispositif de commutation (C) comporte une résistance connectée entre l'entrée de l'étage série et une borne de tension d'alimentation,
-   ■ les étages différentiels de chaque dispositif de commutation (C) étant composés d'au moins un transistor d'entrée et d'au moins un transistor de sortie relié par son collecteur à l'entrée de la bascule qui suit ce dispositif de commutation, l'étage parallèle comporte une pluralité de transistors de sortie dont les émetteurs et les bases sont connectés en parallèle, et dont une partie seulement sont reliés par leur collecteur à l'entrée de la bascule qui suit ce dispositif de commutation, de telle sorte que le courant qui y est délivré par l'étage parallèle soit égal à une fraction du courant de valeur nominale,

-   ■ et les signaux d'horloge et de sélection sont choisis de façon à ce qu'il y ait recouvrement de leurs durées actives.

L'invention permet ainsi de résoudre un problème important lié à l'utilisation de la logique CRL : le risque de saturation du transistor d'entrée de la cellule maître de la bascule maître-esclave qui suit le dispositif de commutation, lors d'un chargement en mode parallèle.

Dans un mode de réalisation préférentiel d'un registre à décalage selon l'invention, l'étage parallèle du dispositif de commutation comporte deux transistors de sortie dont les émetteurs et les bases sont connectés en parallèle, seul l'un des transistors de sortie étant relié par son collecteur à l'entrée de la bascule qui suit ce dispositif de commutation, le collecteur de l'autre transistor de sortie étant relié à la borne de tension d'alimentation.

Ce mode de réalisation présente l'avantage d'être particulièrement simple à mettre en oeuvre.

L'invention a également pour but de proposer un montage comprenant un tel registre à décalage et qui fournit un signal de sélection dont la durée active encadre la période active du signal d'horloge.

Ainsi l'acquisition d'un signal d'entrée de l'étage parallèle par la cellule maître est garantie.

D'autres particularités, détails et avantages de l'invention seront mis en évidence par la description qui va suivre en regard des dessins annexés qui sont relatifs à des exemples donnés à titre non limitatif, dans lesquels:

-   la figure 1 est un schéma représentant un exemple de registre à décalage pouvant être chargé soit en mode série soit en mode parallèle,
-   la figure 2 montre le schéma électrique d'un exemple de réalisation d'un dispositif de commutation d'un registre à décalage selon l'invention,
-   la figure 3 est un diagramme représentant les niveaux de différents signaux qui interviennent dans le fonctionnement du registre à décalage selon l'invention,
-   la figure 4 est un diagramme représentant le signal d'horloge et le signal de sélection en fonction du temps.

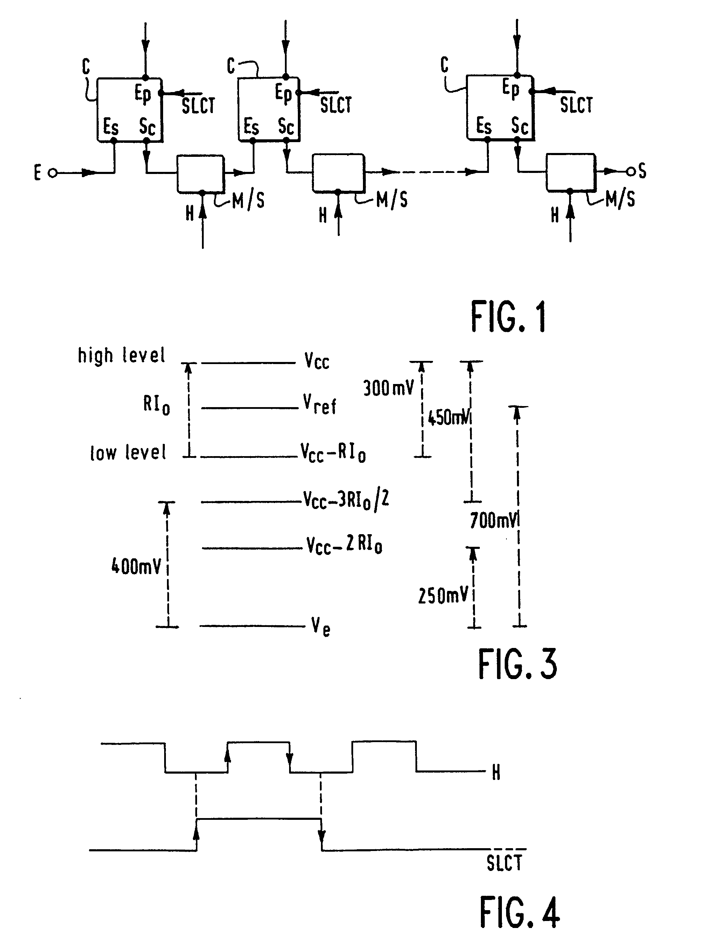

D'après la figure 1, un registre à décalage pouvant être chargé soit en mode série soit en mode parallèle comporte une entrée E utilisée en mode série, reliée à une entrée Es d'un dispositif de commutation C. Il est constitué d'une succession de plusieurs bascules maître-esclave M/S précédées chacune d'un dispositif de commutation C de telle sorte que l'entrée de chaque bascule M/S soit reliée à la sortie Sc d'un dispositif de commutation C, et que la sortie de chaque bascule M/S soit reliée à l'entrée Es, utilisée en mode série, d'un autre dispositif de commutation C. La sortie de la dernière bascule M/S constitue la sortie S du registre à décalage. Chaque dispositif de commutation C dispose également d'une entrée Ep utilisée en mode parallèle. Un signal d'horloge H permet de commander les bascules maître-esclaves M/S, et un signal de sélection SLCT permet de sélectionner le mode de chargement des dispositifs de commutation C.

Dans cet exemple, toutes les bascules maître-esclaves M/S du registre à décalage sont chargées simultanément lorsque l'ensemble des dispositifs de commutation C fonctionnent en mode parallèle. Cela permet d'accéder immédiatement à la donnée chargée dans la dernière bascule.

Selon les applications de ce registre à décalage, il est envisageable de supprimer certains de ces dispositifs de commutation C. En particulier, le signal d'entrée pourrait être directement appliqué à la première bascule M/S du registre à décalage.

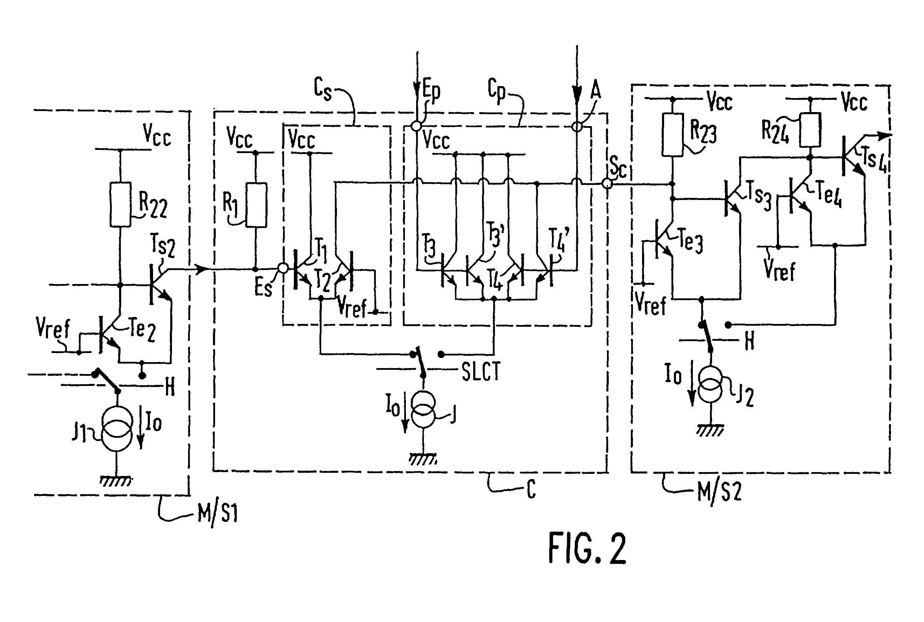

La figure 2 représente un dispositif de commutation C selon l'invention, connecté entre une cellule esclave d'une première bascule maître-esclave M/S1, et une seconde bascule maître-esclave M/S2, toutes deux réalisées en logique CRL.

La cellule esclave de la première bascule maître-esclave M/S1 comporte un transistor d'entrée Te2 et un transistor de sortie Ts2 reliés entre eux par leurs émetteurs. Ces émetteurs sont connectés à une source de courant J1 débitant un courant de valeur nominale Io, exclusivement lorsque le niveau d'un signal d'horloge H est bas. D'autre part, le collecteur du transistor d'entrée Te2 et la base du transistor de sortie Ts2, qui constituent l'entrée de la cellule esclave, sont reliés à une borne de tension d'alimentation Vcc par l'intermédiaire d'une résistance R22. Enfin, la base du transistor d'entrée Te2 est reliée à une borne de tension de référence Vref. Le collecteur du transistor de sortie Ts2 constitue la sortie de la cellule esclave.

Cette sortie est reliée à l'entrée Es du dispositif de commutation C. Le dispositif de commutation C comprend un premier étage différentiel de transistors Cs, dit étage série, et un second étage différentiel de transistors Cp, dit étage parallèle.

L'étage série Cs est composé de deux transistors T1 et T2. La base du transistor T1, qui constitue l'entrée de l'étage série Cs, est reliée d'une part à l'entrée Es du dispositif de commutation C, et d'autre part à la borne de tension d'alimentation Vcc par l'intermédiaire d'une résistance R1. Son collecteur est relié à une borne d'alimentation Vcc, la base de T2 est reliée à la borne de tension de référence Vref et son collecteur à la sortie Sc du dispositif de commutation C. Les émetteurs des deux transistors T1 et T2 sont reliés à une source de courant J, débitant un courant de valeur nominale Io, exclusivement lorsque le niveau d'un signal de sélection SLCT est bas.

L'étage parallèle Cp est composé de quatre transistors T3, T3', T4 et T4'. Les bases des transistors T3 et T3', qui constituent l'entrée de l'étage parallèle Cp, sont reliées à l'entrée parallèle Ep du dispositif de commutation C, et leurs collecteurs sont reliés à la borne d'alimentation Vcc. Les bases des transistors T4 et T4', reliées à un point A, reçoivent l'inverse logique du signal d'entrée utilisé en mode parallèle dans un premier exemple de réalisation, et une tension de référence $V_A$, choisie en fonction de la nature des données chargées en mode parallèle, dans un second exemple de réalisation. Le collecteur du transistor T4 est relié à une borne d'alimentation Vcc et celui du transistor T4' à la sortie Sc du dispositif de commutation C. Les émetteurs des quatre transistors, enfin, sont reliés à la source de courant J exclusivement lorsque le niveau du signal de sélection SLCT est haut. La sortie Sc du dispositif de commutation C est reliée à l'entrée de la seconde bascule maître-esclave M/S2.

Cette bascule M/S2 est composée d'une cellule maître et d'une cellule esclave construites comme cela a été décrit pour la cellule esclave de la première bascule M/S1 : la cellule maître comporte une résistance R23, un transistor d'entrée Te3 et un transistor de sortie Ts3; et la cellule esclave comporte une résistance R24, un transistor d'entrée Te4 et un transistor de sortie Ts4. La cellule maître est alimentée par une source de courant J2, qui délivre un courant de valeur nominale Io, exclusivement lorsque le niveau du signal d'horloge H est haut. Et la cellule esclave est alimentée par cette même source J2 exclusivement lorsque le niveau du signal d'horloge H est bas.

Lorsque le registre à décalage est chargé en série, le signal de sélection SLCT est donc appliqué dans son état bas et l'étage série Cs est alimenté par le courant Io alors que l'étage parallèle Cp n'est pas alimenté. Si le signal d'entrée est dans un état logique haut, le transistor T1 conduit alors que le transistor T2 est bloqué. Aucun courant n'est donc débité dans la résistance R23 de la bascule M/S2 et le potentiel Usc à la sortie Sc du dispositif de commutation C est haut.

Au contraire, si le signal d'entrée est dans un état logique bas, le transistor T1 est bloqué et le transistor T2 conduit, débitant un courant proche de Io dans la résistance R23. Le potentiel Usc à la sortie Sc du dispositif de commutation C est donc bas.

Lorsque le registre est chargé en parallèle, le signal de sélection SLCT est donc appliqué dans son état haut et l'étage série Cs n'est pas alimenté. Si le signal d'entrée est dans un état logique haut, les transistors T3 et T3' conduisent alors que T4 et T4' sont bloqués. Ils ne débitent donc aucun courant dans la résistance R23 et le potentiel Usc à la sortie Sc du dispositif de commutation C est haut.

Au contraire si le signal d'entrée est dans un état logique bas, ce sont les transistors T4 et T4' qui conduisent. Le transistor T4' débite donc un courant lo/2 dans la résistance R23 et dès que la cellule maître de la bascule M/S2 devient active, le potentiel Usc à la sortie Sc du dispositif de commutation passe dans l'état bas.

La double structure de l'étage parallèle Cp permet donc de limiter le courant de sortie à lo/2 en cas de fonctionnement parallèle, c'est-à-dire lorsque le niveau du signal de sélection SLCT est haut. Ainsi, on évite la saturation du transistor d'entrée Te3 de la cellule maître de la bascule M/S2 lorsque le niveau du signal d'entrée est bas. En effet, lorsque le mode de fonctionnement est parallèle et lorsque la cellule maître est active, c'est-à-dire lorsque les niveaux du signal de sélection SLCT et du signal d'horloge H sont hauts, le courant débité dans la résistance R23 est égal à la somme du courant lo/2 débité par le transistor T4' de l'étage parallèle et du courant lo débité par le transistor Te3 de la cellule maître de la bascule M/S2. Le potentiel à la sortie Sc du dispositif de commutation C est donc égal à:

$$Usc = Vcc - 3Rlo/2$$

ce qui évite la saturation qui aurait été atteinte avec une structure simple de l'étage parallèle Cp : le niveau du signal d'entrée étant bas, les transistors Te3 et T4' débiteraient chacun un courant lo, et le potentiel à la sortie Sc du dispositif de commutation C serait égal à:

$$Usc = Vcc - 2Rlo.$$

La figure 3 représente les niveaux de différentes tensions. La tension Vcc correspond au niveau logique haut, la tension (Vcc - Rlo) correspond au niveau logique bas, le potentiel de référence Vref est choisi préférentiellement égal au niveau milieu entre ces deux niveaux logiques, et la tension Ve est la tension émetteur du transistor Te3. Si, par exemple, l'excursion du signal est choisie égale à 300 mV:

$$Rlo = 300 \ mV$$

$$3Rlo/2 = 450 \ mV$$

Dans le cas d'une structure simple de l'étage parallèle Cp, la tension collecteur-émetteur Vce du transistor Te3 est alors égale à:

$$Vce = Usc + Vbe - Vref$$

$$Vce = Vcc - 2Rlo + Vbe - Vcc + Rlo/2$$

$$Vce = Vbe - 3Rlo/2$$

En considérant par exemple que Vbe, tension base-émetteur du transistor Te3, est égale à 700mV, on obtient:

$$Vce = 250 \ mV$$

Le niveau de saturation est donc atteint.
Dans le cas d'une structure double de l'étage parallèle Cp, la tension Vce est de même égale à :

$$Vce = Vbe - Rlo$$

$$Vce = 400 \ mV$$

La saturation est donc évitée.

Il faut noter que le risque de saturation n'existe pas en mode de chargement série. En effet, lorsque les cellules maîtres sont actives, la cellule esclave de la bascule M/S1 n'est pas alimentée. Le potentiel à l'entrée Es du dispositif de commutation C est donc haut, et c'est le transistor T1 qui conduit. Le dispositif de commutation ne débite donc aucun courant dans la résistance R23.

La figure 4 représente le signal de sélection SLCT et le signal d'horloge H en fonction du temps. Le front montant du signal de sélection SLCT précède celui du signal d'horloge H afin de garantir que les données à enregistrer seront présentes sur les entrées de chaque dispositif de commutation lorsque la cellule maître passera en phase de lecture. Le front descendant du signal de sélection SLCT succède à celui du signal d'horloge H de telle sorte que les données d'entrée restent stables tout au long de la phase de lecture de la cellule maître.

C'est ce recouvrement des durées actives de ces deux signaux SLCT et H qui permet d'utiliser une double structure de l'étage parallèle Cp. En effet, le signal d'entrée utilisé en mode parallèle étant dans un état bas, le courant de sortie du dispositif de commutation C est limité à lo/2 et le potentiel Usc sur sa sortie Sc ne passe à l'état bas que lorsque la cellule maître devient active. Cela signifie que l'état bas n'est enregistré que s'il y a recouvrement des durées actives des deux signaux de sélection SLCT et d'horloge H.

Bien que l'invention ait été décrite d'après un exemple concret de réalisation, il reste entendu que des variantes, facilement imaginables par l'homme de l'art, sont possibles et que ces variantes appartiennent au domaine de l'invention.

En particulier, les niveaux actifs des signaux d'horloge H et de sélection SLCT peuvent être choisis de façon à correspondre à un niveau logique bas.

D'autre part, dans la structure de limitation du courant de sortie en cas de chargement parallèle décrite précédemment, le nombre N des transistors de sortie de l'étage parallèle est égal à deux, l'un seulement de ces transistors étant relié par son collecteur à la sortie Sc du dispositif. Cette valeur de N est particulièrement bien adaptée puisqu'elle permet d'obtenir le résultat recherché avec une structure simple, mais il est possible d'utiliser des valeurs différentes. Le nombre de transistors dont les collecteurs sont reliés à la sortie du dispositif est alors déterminé de telle sorte que le courant disponible à la sortie du dispositif soit égal à une fraction comprise entre 1 et 1/2 du courant Io débité par la source de courant J.

Enfin, l'excursion du signal a été choisie égale à 300 mV dans la description précédente. Cette valeur est particulièrement bien adaptée puisqu'elle permet d'une part de ne pas être trop proche de la saturation et d'autre part de ne pas être trop sensible au bruit. Bien entendu, elle n'est pas limitative et d'autres valeurs proches pourraient également convenir.

De même, la première tension de référence Vref a été préférentiellement choisie égale au niveau milieu entre le niveau logique haut et le niveau logique bas. D'autres valeurs de Vref, comprises entre ces deux niveaux, pourraient être déterminées par l'homme de l'art.

## Revendications

1. Registre à décalage numérique comportant une succession de plusieurs bascules maîtres-esclaves (M/S) commandées par un signal d'horloge (H) afin de charger en série des données présentes à l'entrée (E) du registre à décalage, certaines de ces bascules (M/S) étant séparées par un dispositif de commutation (C) qui comporte :

  - un étage différentiel de transistors (Cs), dit étage série,
  - un étage différentiel de transistors (Cp), dit étage parallèle,
  - et un circuit commutateur (J, SLCT) qui permet de fournir un courant (Io), dit courant de valeur nominale, soit à l'étage série (Cs) soit à l'étage parallèle (Cp) en fonction d'un signal de sélection (SLCT), pour charger la bascule (M/S2) qui suit ce dispositif de commutation (C) soit en mode série, soit en mode parallèle, à partir de données présentes soit sur une entrée (Es) de l'étage série (Cs), soit sur une entrée (Ep) de l'étage parallèle (Cp), caractérisé en ce que,

    ■ les bascules maîtres-esclaves (M/S) étant réalisées à partir de cellules en logique CRL, le dispositif de commutation (C) comporte une résistance (R1) connectée entré l'entrée (Es) de l'étage série (Cs) et une borne de tension d'alimentation (Vcc),
    ■ les étages différentiels de chaque dispositif de commutation (C) étant composés d'au moins un transistor d'entrée ($T_1$, $T_3$, $T_3'$) et d'au moins un transistor de sortie ($T_2$, $T_4'$) relié par son collecteur à l'entrée de la bascule (M/S2) qui suit ce dispositif de commutation (C), l'étage parallèle (Cp) comporte une pluralité de transistors de sortie (T4, T4') dont les émetteurs et les bases sont connectés en parallèle, et dont une partie seulement (T4') sont reliés par leur collecteur à l'entrée de la bascule (M/S2) qui suit ce dispositif de commutation (C), de telle sorte que le courant qui y est délivré par l'étage parallèle soit égal à une fraction du courant de valeur nominale (Io),
    ■ les signaux d'horloge (H) et de sélection (SLCT) sont choisis de façon à ce qu'il y ait recouvrement de leurs durées actives.

2. Registre à décalage selon la revendication 1, caractérisé en ce que, l'étage parallèle (Cp) du dispositif de commutation (C) comporte deux transistors de sortie (T4, T4') dont les émetteurs et les bases sont connectés en parallèle, seul l'un des transistors de sortie (T4') étant relié par son collecteur à l'entrée de la bascule (M/S2) qui suit ce dispositif de commutation (C), le collecteur de l'autre transitor de sortie (T4) étant relié à la borne de tension d'alimentation (Vcc).

3. Montage comprenant un registre à décalage selon l'une des revendications 1 ou 2, caractérisé en ce qu'il fournit un signal de sélection (SLCT) dont la durée active encadre la période active du signal d'horloge (H).

## Patentansprüche

1. Numerisches Schieberegister mit einer Folge mehrerer von einem Taktsignal (H) gesteuerter Master-Slave-Umschalter (M/S), um eine Serie der am Eingang (E) des Schieberegisters vorhandenen Daten zu laden, während bestimmte dieser Umschalter (M/S) von einer Umschaltvorrichtung (C) getrennt sind, die enthält :

  - eine Transistor-Differentialstufe (Cs), die sogenannte Serienstufe,
  - eine Transistor-Differentialstufe (cp), die sogenannte Parallelstufe,
  - und einen Schaltkreis (J, SLCT), der die Lieferung eines Stroms (Io), den sogenannten Nennwertstrom, entweder an die Serienstufe (Cs) oder an die Parallelstufe (Cp) ermöglicht, abhängig von einem Auswahlsignal (SLCT), um den Umschalter (M/S2) zu laden, der dieser Umschaltvorrichtung (C) entweder in Serienmodus oder in Parallelmodus folgt, ausgehend von entweder an einem Eingang (Es) der Serienstufe (Cs) oder an einem Eingang (Ep) der Parallelstufe (Cp) vorhandener Daten, dadurch gekennzeichnet, daß

- ■ die Master-Slave-Umschalter (M/S) anhand von Zellen in CRL-Logik verwirklicht werden, die Umschaltvorrichtung (C) enthält einen zwischen dem Eingang (Es) der Serienstufe (Cs) und einer Versorgungsspannungsklemme (Vcc) angeschlossenen Widerstand (R1),
- ■ die Differentialstufen jeder Umschaltvorrichtung (C) sich aus mindestens einem Eingangstransistor (T1, T3, T3') und mindestens einem Ausgangstransistor (T2, T4') zusammensetzen, über seinen Kollektor mit dem Eingang des Umschalters (M/S2) verbunden, der dieser Umschaltvorrichtung (C) folgt, die Parallelstufe (Cp) enthält eine Vielzahl Ausgangstransistoren (T4, T4'), deren Emitter und Basen parallel geschaltet sind und von denen nur ein Teil (T4') über ihren Kollektor mit dem Eingang des Umschalters (M/S2) verbunden sind, der dieser Umschaltvorrichtung (C) folgt, derart, daß der Strom dort von der Parallelstufe abgegeben wird und somit gleich einem Bruchteil des Nennwertstroms (Io) ist,
- ■ und dadurch, daß die Takt- (H) und Auswahlsignale (SLCT) derart gewählt werden, daß ihre Aktivzeiten rückgewonnen werden.

2. Schieberegister nach Anspruch 1, dadurch gekennzeichnet, daß die Parallelstufe (Cp) der Umschaltvorrichtung (C) zwei Ausgangstransistoren (T4, T4') enthält, deren Emitter und Basen parallel geschaltet sind, wobei nur einer der Ausgangstransistoren (T4') über seinen Kollektor zum Eingang des Umschalters (M/S2) verbunden ist, der dieser Umschaltvorrichtung (C) folgt, während der Kollektor des anderen Ausgangstransistors (T4) mit der Versorgungsspannungsklemme (Vcc) verbunden ist.

3. Schaltkreis mit einem Schieberegister nach einem der Ansprüche 1 oder 2, dadurch gekennzeichnet, daß er ein Auswahlsignal (SLCT) liefert, dessen Aktivzeit die Aktivzeit des Taktsignals (H) umrgrenzt.

**Claims**

1. A digital shift register, comprising a succession of master-slave flipflops (M/S) which are controlled by a clock signal (H) for the serial loading of the data present at the input (E) of the shift register, given flipflops (M/S) being separated by a switching device (C) which comprises:

- a differential stage comprising transistors which is referred to as a serial stage (Cs),
- a differential stage comprising transistors which is referred to as a parallel stage (Cp),
- and a switching circuit (J, SLCT) which enables a current (Io), referred to as a current of nominal value, to be applied either to the serial stage (Cs) or to the parallel stage (Cp), as a function of a selection signal (SLCT), in order to load the flipflop (M/S2) succeeding this switching device (C) either in the serial or in the parallel mode on the basis of data present either at an input (Es) of the serial stage (Cs) or at an input (Ep) of the parallel stage (Cp),

characterized in that,

- the master-slave flipflops (M/S) being realised on the basis of CRL cells, the switching device (C) comprises a resistance (R1) which is connected between the input (Es) of the serial stage (Cs) and a supply voltage terminal (Vcc),
- the differential stages of each switching device (C) being composed of at least one input transistor (T1, T3, T3') and at least one output transistor (T2, T4') connected by way of its collector, to the input of the flipflop (M/S2) succeeding this switching device (C), the parallel stage (Cp) comprises a plurality of output transistors (T4, T4') whose emitters and bases are connected in parallel, and only a part (T4') of which are connected, by way of their collector, to the input of the flipflop (M/S2) succeeding this switching device (C), so that the current supplied by the parallel stage is equal to a fraction of the current of nominal value (Io),
- the clock (H) and selection (SLCT) signals are chosen so that their active durations overlap.

2. A shift register as claimed in Claim 1, characterized in that the parallel stage (Cp) of the switching device (C) comprises two output transistors (T4, T4') whose emitters and bases are connected in parallel, only one of the output transistors (T4') being connected, by way of its collector, to the input of the flipflop (M/S2) succeeding the switching device (C), the collector of the other output transistor (T4) being connected to the supply voltage terminal (Vcc).

3. An arrangement comprising a shift register as claimed in one of the Claims 1 or 2, characterized in that it supplies a selection signal (SLCT) whose active duration encloses the active period of the clock signal (H).

EP 0 597 535 B1

FIG. 1

FIG. 3

FIG. 4

FIG. 2